**Europäisches Patentamt**

**European Patent Office**

**Office européen des brevets**

(19)

(11) Numéro de publication : **0 689 061 A1**

# (12) DEMANDE DE BREVET EUROPEEN

(21) Numéro de dépôt : **95401450.2**

(51) Int. Cl.⁶ : **G01R 31/36**

(22) Date de dépôt : **20.06.95**

(30) Priorité : **24.06.94 FR 9407806**

(43) Date de publication de la demande :
**27.12.95 Bulletin 95/52**

(84) Etats contractants désignés :
**CH DE ES FR GB IT LI NL SE**

(71) Demandeur : **ALCATEL ALSTHOM COMPAGNIE GENERALE D'ELECTRICITE**
**54, rue La Boétie**
**F-75008 Paris (FR)**

(72) Inventeur : **Andrieu, Xavier**
**13, rue des Noyers**
**F-91220 Bretigny Sur Orge (FR)**
Inventeur : **Poignant, Philippe**
**36, rue Charles Peguy**
**F-91120 Palaiseau (FR)**

(74) Mandataire : **Scheer, Luc et al**
**SOSPI**
**14-16, rue de la Baume**
**F-75008 Paris (FR)**

(54) **Dispositif de mesure de l'état de charge d'un générateur électrochimique**

(57)  L'invention concerne un dispositif de mesure de l'état de charge d'un générateur électrochimique (10) comprenant une résistance parasite. Le dispositif comprend :

— des moyens (11, 13) pour imposer au générateur électrochimique (10) une tension de référence (Vd) inférieure à sa tension nominale (Vb), de manière à lui faire débiter un courant de décharge ;

— des moyens de mesure (15) du courant de décharge fournissant une indication de l'état de charge du générateur électrochimique (10) ;

— des moyens de correction (50) de la tension de référence en fonction du courant de décharge, les moyens de correction (50) fournissant une tension de référence corrigée (Vs) compensant la résistance parasite.

FIG.5

EP 0 689 061 A1

Le domaine de l'invention est celui des dispositifs permettant d'indiquer l'état de charge d'un générateur électrochimique constitué par exemple par un accumulateur ou par une batterie d'accumulateurs. On entend par batterie d'accumulateurs un ensemble constitué par une pluralité de cellules d'accumulateurs connectées en série.

De façon connue, la caractéristique de tension d'un accumulateur en fonction de sa capacité de décharge, par exemple exprimée en Ah, ne présente pas de variation importante pour une grande majorité de caractéristiques de décharge et il n'est donc pas possible de déterminer l'état de charge de cet accumulateur en effectuant une simple mesure de tension à ses bornes.

La demande de brevet français publiée sous le n°2.685.780 décrit notamment un procédé de mesure de l'état de charge d'un générateur électrochimique, du type consistant à appliquer une contrainte impulsionnelle à ce générateur et à observer sa réponse à cette contrainte pour estimer son état de charge. Ce procédé consiste à :

- appliquer au générateur électrochimique une impulsion de tension de valeur inférieure à sa tension nominale, de façon à lui faire délivrer un courant de décharge, la valeur de ce courant de décharge étant telle que le générateur présente une caractéristique univoque d'impédance interne en fonction de son état de charge ;
- mesurer ce courant de décharge pour estimer l'état de charge du générateur électrochimique.

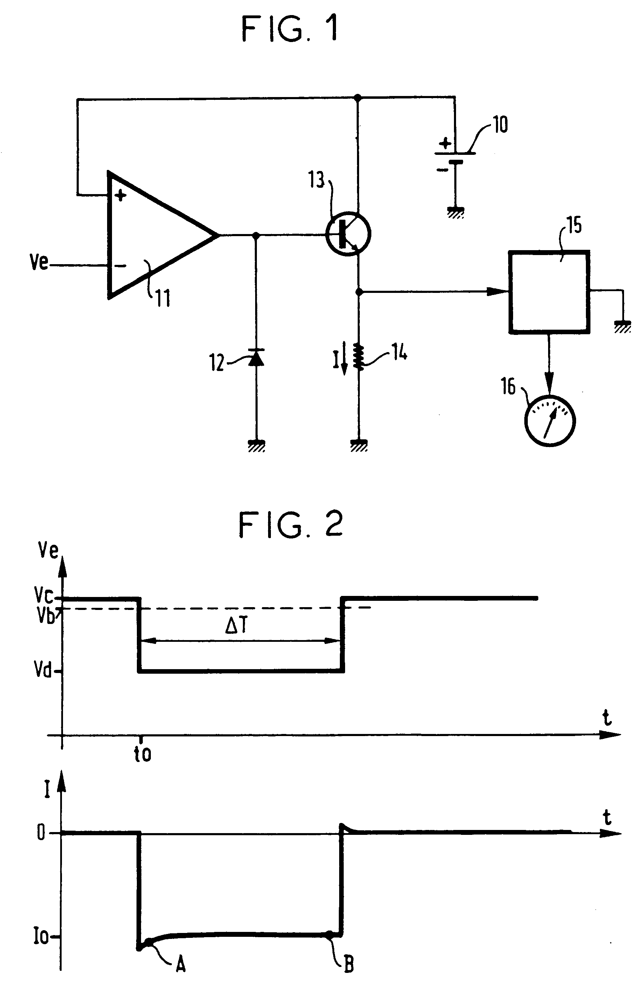

La figure 1 représente un mode de réalisation d'un dispositif mettant en oeuvre ce procédé.

Ce dispositif a pour fonction de mesurer l'état de charge d'un accumulateur 10. Un signal Ve de commande est appliqué à l'entrée inverseuse d'un amplificateur opérationnel 11 dont l'entrée non-inverseuse est reliée à l'électrode positive de l'accumulateur 10. L'électrode négative de l'accumulateur 32 est connectée à la masse. La sortie de l'amplificateur opérationnel 11 est reliée d'une part à la cathode d'une diode de protection 12, dont l'anode est reliée à la masse, et d'autre part à la base d'un moyen de commutation 13, ici constitué par un transistor. L'émetteur du transistor 13 est relié à la masse par l'intermédiaire d'une résistance shunt 14, traversée par un courant I lorsque le transistor 13 est saturé, et son collecteur à l'entrée non-inverseuse de l'amplificateur opérationnel 11. L'émetteur est également relié à un dispositif de traitement 15 de la tension aux bornes de la résistance 14 coopérant avec un indicateur 16 de l'état de charge de l'accumulateur 10.

Le fonctionnement de ce dispositif est décrit en référence à la figure 2 qui représente deux chronogrammes corrélatifs de la tension Ve et du courant I en fonction du temps :

Le signal de commande Ve présente une tension Vc supérieure à la tension de l'accumulateur 10, notée Vb, lorsqu'aucune impulsion permettant d'estimer l'état de charge de l'accumulateur 10 n'est générée. La tension de sortie de l'amplificateur opérationnel 11 est donc égale à 0 ou négative. Le transistor 13 est bloqué et aucun courant ne traverse la résistance shunt 14. Cet état correspond à un état de repos du système de mesure d'état de charge.

A un temps t0, le signal Ve passe à une tension de décharge Vd. Ce brusque changement du signal de commande correspond à une impulsion potentiostatique de durée T destinée à permettre la mesure de l'état de charge de l'accumulateur 10. La tension de sortie de l'amplificateur 11 passe alors à Vd (aux chutes de tension près), c'est à dire à une tension inférieure à Vb. La tension aux bornes de l'accumulateur 10 est alors égale à Vd et un courant important traverse la résistance shunt 14. Ce courant, noté Io, varie dans le même sens que l'admittance présentée par l'accumulateur 10.

Le chronogramme I=f(t) de la figure 2 montre l'évolution du courant I traversant la résistance shunt 14. Au temps t0, la décharge impulsionnelle présente un pic, puis se stabilise à une valeur Io. Ce courant Io peut être très important, par exemple de l'ordre de 15A pour des accumulateurs Nickel-Cadmium de petite capacité. La mesure du courant Io par le dispositif 15 permet de déterminer l'état de charge de l'accumulateur 10 et de l'afficher sur l'indicateur 16. Le dispositif 15 peut déterminer soit l'admittance, soit l'impédance de l'accumulateur 10. La durée $\Delta t$ de l'impulsion est préférentiellement suffisamment importante pour que la mesure de Io soit effectuée à un moment éloigné temporellement du début de l'impulsion. En effet, la variation du courant Io au début de l'impulsion est importante et la mesure de Io à un point A ne sera pas aussi précise que celle effectuée à un point B situé préférentiellement à un instant précédant immédiatement le temps t0+$\Delta T$ où le signal de commande Ve repasse à Vc, mettant ainsi fin à la mesure de l'état de charge. L'instant de mesure correspond au moment où la tension aux bornes de la résistance 14 est mesurée.

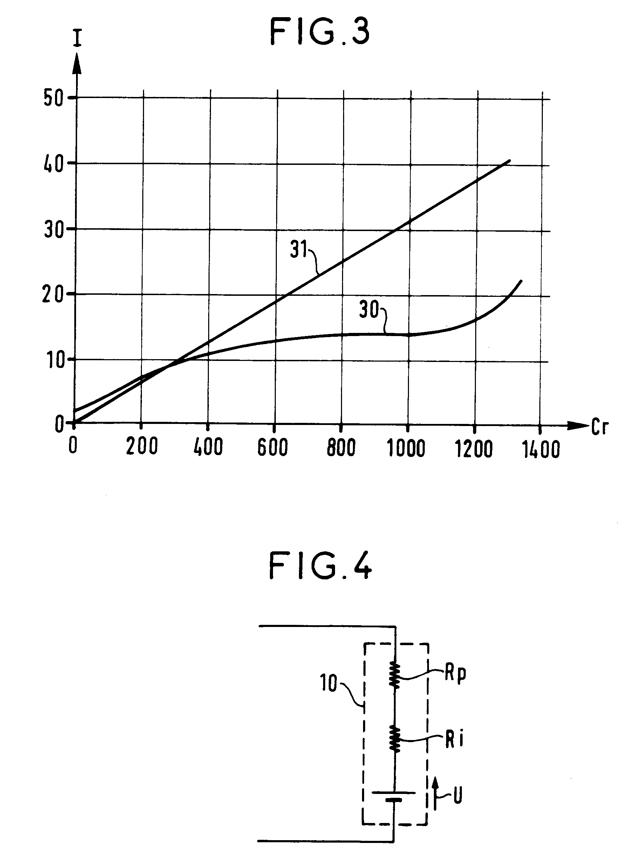

Un dispositif de ce type a donné de bons résultats pour des générateurs de type Ni-Cd de petit format : la dynamique des signaux est significative et la reproductibilité satisfaisante. En revanche il s'est avéré que son application à des générateurs de type Ni-MH de mêmes dimensions ou à des générateurs de type VECS 1,3 Ah n'est pas satisfaisante car leurs caractéristiques de courant délivré en fonction de la capacité résiduelle présente un plateau, comme représenté à la figure 3.

La figure 3 représente la caractéristique 30 du courant I (exprimé en Ampères) délivré par une batterie d'accumulateurs constituée de 5 cellules Ni-Cd VECS de capacité 1300 mA en fonction de sa capacité résiduelle Cr (exprimée en mAh).

On constate que la caractéristique 30, pour des états de charge compris entre 30 et 80% de la capacité nominale, présente un plateau, et il est donc difficile d'estimer l'état de charge dans cet intervalle. Une caractéristique idéale est représentée par la droite 31 et une estimation optimale d'un état de charge supposerait que la caractéristique I=f(Cr) de l'accumulateur testé soit aussi proche que possible de cette droite 31. L'allure de la caractéristique 30 est due à une résistance parasite présente dans l'accumulateur testé, cette résistance parasite étant représentée sur la figure 4.

La figure 4 représente un schéma équivalent d'un générateur électrochimique 10.

Ce schéma équivalent comporte en série une source de tension U, une résistance interne Ri qui est fonction de l'état de charge du générateur électrochimique et une résistance parasite Rp. La résistance parasite Rp est à l'origine du plateau de la figure 3 et provient de paramètres tels que la constitution du générateur, la nature de son couple électrochimique ou les liaisons inter-cellules (dans le cas d'une batterie d'accumulateurs reliés en série).

La présente invention a notamment pour objectif de remédier à cet inconvénient en fournissant un dispositif de mesure de l'état de charge d'un générateur électrochimique, ce dispositif mettant en oeuvre le procédé décrit précédemment, où la résistance parasite du générateur testé est compensée.

Cet objectif, ainsi que d'autres qui apparaîtront par la suite, est atteint grâce à un dispositif de mesure de l'état de charge d'un générateur électrochimique comprenant une résistance parasite, ce dispositif comprenant :

- des moyens pour imposer au générateur électrochimique une tension de référence inférieure à sa tension nominale, de manière à lui faire débiter un courant de décharge ;
- des moyens de mesure du courant de décharge fournissant une indication de l'état de charge du générateur électrochimique,

ce dispositif comportant également des moyens de correction de la tension de référence en fonction du courant de décharge, ces moyens de correction fournissant une tension de référence corrigée compensant la résistance parasite.

Dans un mode de réalisation avantageux, les moyens de correction comportent un amplificateur opérationnel fournissant la tension de référence corrigée égale à :

$$Vs = Vd + Rp.Io$$

où Vd est une tension inférieure à la tension nominale du générateur électrochimique, Rp est la résistance parasite et Io le courant de décharge.

D'autres caractéristiques de l'invention apparaîtront à la lecture de la description suivante d'un mode de réalisation préférentiel, donné à titre illustratif et non limitatif, et des dessins annexés dans lesquels :

- la figure 1 représente un mode de réalisation d'un dispositif de mesure de l'état de charge d'un générateur électrochimique, tel que décrit dans la demande de brevet français n°2.685.780 ;
- la figure 2 est un chronogramme corrélatif de signaux mesurés sur le dispositif de la figure 1 ;
- la figure 3 représente la caractéristique du courant délivré par un générateur électrochimique en fonction de sa capacité résiduelle, cette caractéristique faisant apparaître une diminution de variation de courant dans une plage de capacité résiduelle importante ;
- la figure 4 est un schéma équivalent d'un générateur électrochimique, ce schéma équivalent faisant apparaître une résistance parasite ;
- la figure 5 représente un mode de réalisation préférentiel du dispositif selon l'invention ;
- la figure 6 représente la caractéristique I = f(Cr) d'une batterie de 5 accumulateurs de type VECS, cette caractéristique étant mesurée sans puis avec le dispositif de correction de l'invention.

Les figures 1 à 4 ont été décrites précédemment en référence à l'état de la technique.

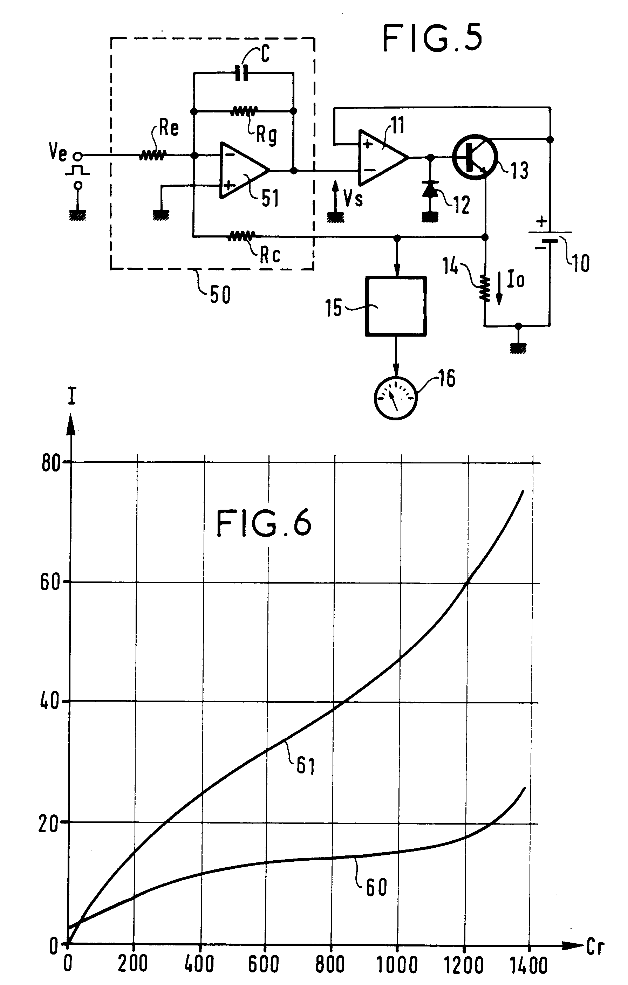

La figure 5 représente un mode de réalisation préférentiel du dispositif selon l'invention. Ce dispositif fonctionne de la même manière que le précédent à la différence près que le signal de commande Ve est une impulsion positive et qu'un étage inverseur 50 sépare l'application de Ve de l'amplificateur opérationnel 11.

Ce dispositif se distingue de celui de la figure 1 en ce que les moyens pour imposer au générateur électrochimique 10 une tension de référence comprennent des moyens de correction de la résistance parasite présentée par le générateur 10. Ces moyens de correction sont globalement référencés par 50 et sont ici réalisés sous la forme d'un sommateur-inverseur construit autour d'un amplificateur opérationnel 51. Une résistance Rg fixe le gain de l'amplificateur 51. La tension de référence Ve est appliquée à l'extrémité d'une résistance d'entrée Re et une tension de compensation égale à Rs.Io à l'extrémité d'une résistance de correction Rc. Le courant Io est le courant de décharge du générateur 10. La résistance Rc a une forte valeur pour ne pas perturber la mesure du courant Io par le dispositif de traitement 15. La tension de sortie des moyens de correction 50 est égale à Vs = -Rg.(Ve/Re + Rs.Io/Rc). Cette tension est appliquée sur l'entrée inverseuse de l'amplificateur opérationnel 11 et constitue une tension de référence corrigée.

La valeur de (Rg.Rs)/Rc correspond à la correction de la résistance parasite Rp que l'on souhaite compenser. Ainsi, la valeur de Rc doit être égale à (Rg.Rs)/Rp, c'est à dire inversement proportionnelle à la résistance parasite Rp. En normalisant, on obtient une impulsion potentiostatique d'amplitude Vs = Vd + Rp.Io.

La correction apportée consistant en une réaction positive, on veillera à ne pas surcompenser la résistance parasite, faute de quoi le dispositif de mesure d'état de charge deviendrait instable. Par ailleurs, du fait de cette réaction positive, le dispositif aura tendance à augmenter de plus en plus la contrainte potentiostatique, jusqu'à ce que l'impulsion d'entrée disparaîsse. Ceci ne pose pas de problème si la durée $\Delta T$ de l'impulsion est courte, ce qui est le cas.

On prévoit avantageusement une compensation en température du dispositif de mesure, cette compensation en température consistant à placer en série avec la résistance de correction Rc une résistance de type CTP, éventuellement en parallèle avec une résistance d'ajustement de la caractéristique de cette résistance CTP.

Afin de supprimer le pic de courant obtenu lors de l'application de la tension de référence, on placera avantageusement un condensateur C en parallèle avec la résistance Rg, de façon à former un intégrateur.

Le transistor 13 peut être remplacé par tout autre moyen de commutation, par exemple par un transistor MOSFET de puissance.

La figure 6 représente la caractéristique I = f(Cr) d'une batterie de 5 accumulateurs de type VECS, cette caractéristique étant mesurée sans puis avec le dispositif de correction de l'invention. Les cellules sont connectées en série, sont de marque SAFT et ont une capacité nominale de 1,3 Ah. La résistance de correction Rc a ici une valeur de 10 k$\Omega$.

Les échelles sont les mêmes que celles de la figure 3 et la caractéristique 60 correspond à la caractéristique 30 de la figure 3. Aucune correction n'est réalisée. En employant le dispositif de l'invention, on obtient la caractéristique 61. Cette caractéristique est exempte de plateau et est proche d'une droite. Il en résulte que l'estimation de l'état de charge est grandement facilitée.

## Revendications

1. Dispositif de mesure de l'état de charge d'un générateur électrochimique (10) comprenant une résistance parasite (Rp), ledit dispositif comprenant :
   - des moyens (11, 13) pour imposer audit générateur électrochimique (10) une tension de référence (Vd) inférieure à sa tension nominale (Vb), de manière à lui faire débiter un courant de décharge (Io);
   - des moyens de mesure (15) dudit courant de décharge (Io) fournissant une indication de l'état de charge dudit générateur électrochimique (10),

   caractérisé en ce qu'il comporte également des moyens de correction (50) de ladite tension de référence (Vd) en fonction dudit courant de décharge (Io), lesdits moyens de correction (50) fournissant une tension de référence corrigée (Vs) compensant ladite résistance parasite (Rp).

2. Dispositif selon la revendication 1, caractérisé en ce que lesdits moyens de correction comportent un amplificateur opérationnel (51) fournissant ladite tension de référence corrigée (Vs) égale à :

   $$Vs = Vd + Rp.Io$$

   où Vd est une tension inférieure à ladite tension nominale (Vb) dudit générateur électrochimique (10), Rp est ladite résistance parasite et Io ledit courant de décharge.

# FIG. 1

# FIG. 2

## FIG.3

## FIG.4

# FIG.5

# FIG.6

**Office européen des brevets**

# RAPPORT DE RECHERCHE EUROPEENNE

Numero de la demande

EP 95 40 1450

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A,D | EP-A-0 549 464 (ALCATEL) <br> * abrégé; figures 3,4 * <br> --- | 1,2 | G01R31/36 |
| A | PATENT ABSTRACTS OF JAPAN <br> vol. 17 no. 626 (P-1647) ,18 Novembre 1993 <br> & JP-A-05 203684 (SHARP) 10 Août 1993, <br> * abrégé * <br> ----- | 1,2 | |

**DOMAINES TECHNIQUES RECHERCHES (Int.Cl.6)**

G01R

Le présent rapport a été établi pour toutes les revendications

| Lieu de la recherche | Date d'achèvement de la recherche | Examinateur |
|---|---|---|
| LA HAYE | 4 Octobre 1995 | Iwansson, K |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................................

& : membre de la même famille, document correspondant

EPO FORM 1503 03.82 (P04C02)

8